# EUROPEAN PATENT APPLICATION

(11) **EP 4 593 547 A1**
(43) Date of publication of application: **30.07.2025**
(21) Application number: 24196908.8
(22) Date of filing: 28.08.2024
(51) Int. Cl.: H10B 43/10, H10B 43/27

(54) **SEMICONDUCTOR DEVICES AND DATA STORAGE SYSTEMS INCLUDING THE SAME**

(30) Priority: 25.01.2024 KR 20240011414
(71) Applicant: Samsung Electronics Co., Ltd., Gyeonggi-do, 16677 (KR)
(72) Inventor: KIM, Doyoung, 16677 Suwon-si (KR); KANG, Shinhwan, 16677 Suwon-si (KR); SUNG, Sukkang, 16677 Suwon-si (KR); SON, Younghwan, 16677 Suwon-si (KR)
(74) Representative: Marks & Clerk LLP

(57) **Abstract**

A semiconductor device includes a plate layer, gate electrodes including a lower gate electrode, memory gate electrodes, and an upper gate electrode, channel structures in channel holes penetrating through the gate electrodes, a cell region insulating layer on the channel structures, studs penetrating through the cell region insulating layer and connected to the channel structures, respectively, first separation regions penetrating through the gate electrodes, and a second separation region penetrating through the upper gate electrode between the studs, wherein side surfaces of the second separation region include round portions and straight portions between the round portions, each of the gate electrodes includes a first conductive layer and a second conductive layer, and the second separation region is in contact with the first conductive layer and the second conductive layer of the upper gate electrode.

## Description

### BACKGROUND

The present disclosure relates to semiconductor devices and data storage systems including the same.

In a data storage system requiring data storage, a semiconductor device capable of storing high-capacitance data is required. Accordingly, manners to increase the data storage capacity of the semiconductor device are being researched. For example, as one manner to increase the data storage capacitance of the semiconductor device, a semiconductor device including memory cells arranged three-dimensionally instead of memory cells arranged two-dimensionally has been proposed.

### SUMMARY

Some example embodiments of the present disclosure provide semiconductor devices having improved reliability and mass productivity.

Some example embodiments of the present disclosure provide data storage systems including a semiconductor device having improved reliability and mass productivity.

According to an example embodiment of the present disclosure, a semiconductor device includes a first semiconductor structure including a substrate, circuit elements on the substrate, and circuit interconnections on the circuit elements, and a second semiconductor structure on the first semiconductor structure, wherein the second semiconductor structure includes a plate layer, gate electrodes stacked on the plate layer and spaced apart from each other in a first direction perpendicular to an upper surface of the plate layer, the gate electrodes including a lower gate electrode, memory gate electrodes, and an upper gate electrode sequentially stacked on the plate layer, interlayer insulating layers alternately stacked with the gate electrodes, channel structures in channel holes penetrating through a stack structure of the gate electrodes and the interlayer insulating layers, a cell region insulating layer on the channel structures, studs penetrating through the cell region insulating layer and connected to the channel structures, respectively, and the studs being in rows in a second direction perpendicular to the first direction, first separation regions penetrating through the stack structure and extending in the second direction, and a second separation region penetrating through the cell region insulating layer and the upper gate electrode, the second separation region extending in the second direction and being between two adjacent rows of the studs, wherein the second separation region may overlap the two adjacent rows of the studs in the second direction, and wherein an upper surface of the second separation region may be coplanar with upper surfaces of the studs.

According to an example embodiment of the present disclosure, a semiconductor device includes a plate layer, gate electrodes stacked on the plate layer and spaced apart from each other in a first direction perpendicular to an upper surface of the plate layer, and including a lower gate electrode, memory gate electrodes, and an upper gate electrode sequentially stacked from the plate layer, channel structures in channel holes penetrating through the gate electrodes, a cell region insulating layer on the channel structures, studs penetrating through the cell region insulating layer and connected to the channel structures, respectively, first separation regions penetrating through the gate electrodes and extending in a second direction, perpendicular to the first direction, and a second separation region penetrating through the upper gate electrode, extending in the second direction, and being between the studs, wherein side surfaces of the second separation region include round portions surrounding the studs and straight portions extending in the second direction between the round portions, wherein each of the gate electrodes includes a first conductive layer and a second conductive layer covering an upper surface and a lower surface of the first conductive layer, and wherein the second separation region is in contact with the first conductive layer and the second conductive layer of the upper gate electrode.

According to an example embodiment of the present disclosure, a data storage system includes a semiconductor storage device including a first semiconductor structure including circuit elements, a second semiconductor structure on a surface of the first semiconductor structure, and an input/output pad electrically connected to the circuit elements, and a controller electrically connected to the semiconductor storage device through the input/output pad and configured to control the semiconductor storage device, wherein the second semiconductor structure includes a plate layer, gate electrodes stacked on the plate layer and spaced apart from each other in a first direction perpendicular to an upper surface of the plate layer, the gate electrodes including a lower gate electrode, memory gate electrodes, and an upper gate electrode sequentially stacked from the plate layer, channel structures in channel holes penetrating through the gate electrodes, a cell region insulating layer on the channel structures, studs penetrating through the cell region insulating layer and connected to the channel structures, respectively, first separation regions penetrating through the gate electrodes and extending in a second direction perpendicular to the first direction, and a second separation region penetrating through the cell region insulating layer and the upper gate electrode, the second separation region extending in the second direction and being between the studs, and wherein the second separation region may not overlap the channel structures in the first direction and may overlap some of the studs in the second direction.

A second separation region to be aligned may be disposed between studs, thereby providing a semiconductor device having improved reliability and mass productivity and a data storage system including the same.

Advantages and effects of the present disclosure are not limited to the foregoing content and may be more easily understood in the process of understanding the disclosed specific example embodiments of the present disclosure.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a schematic plan view of a semiconductor device according to an example embodiment;
FIGS. 2A and 2B are schematic cross-sectional views of a semiconductor device according to an example embodiment;
FIGS. 3A and 3B are schematic partially enlarged views of a semiconductor device according to an example embodiment;
FIG. 4 is a schematic plan view of a semiconductor device according to an example embodiment;
FIGS. 5A and 5B are a schematic plan view and a cross-sectional view of a semiconductor device according to an example embodiment;
FIG. 6 is a schematic cross-sectional view of a semiconductor device according to an example embodiment;
FIG. 7 is a schematic cross-sectional view of a semiconductor device according to an example embodiment;
FIG. 8 is a schematic cross-sectional view of a semiconductor device according to an example embodiment;
FIGS. 9A to 9I are schematic cross-sectional views for describing a method of manufacturing a semiconductor device according to an example embodiment;
FIG. 10 is a view schematically illustrating a data storage system including a semiconductor device according to an example embodiment;
FIG. 11 is a perspective view schematically illustrating a data storage system including a semiconductor device according to an example embodiment; and
FIG. 12 is a cross-sectional view schematically illustrating a semiconductor package according to an example embodiment.

### DETAILED DESCRIPTION

Hereinafter, example embodiments of the present disclosure will be described with reference to the accompanying drawings.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

Expressions such as "at least one of," when preceding a list of elements, modify the entire list of elements and do not modify the individual elements of the list. For example, an expression such as "at least one of A, B, and C" or "at least one selected from the group consisting of A, B, and C" may be interpreted as only A, only B, only C, or any combination of two or more of A, B, and C, such as A, B, and C, A and B, B and C, and A and C.

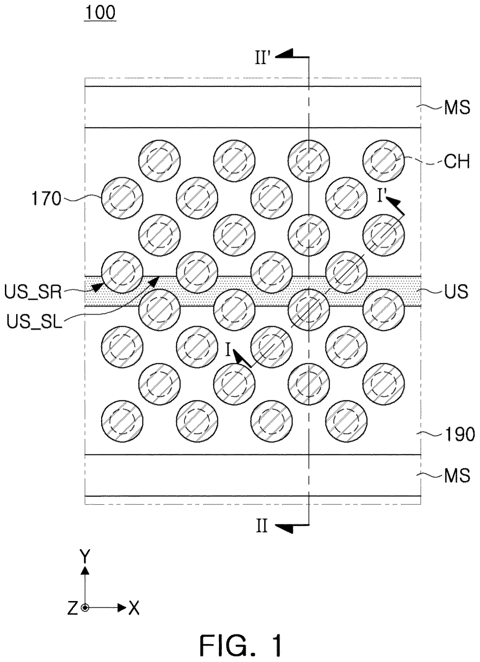

FIG. 1 is a schematic plan view of a semiconductor device according to an example embodiment.

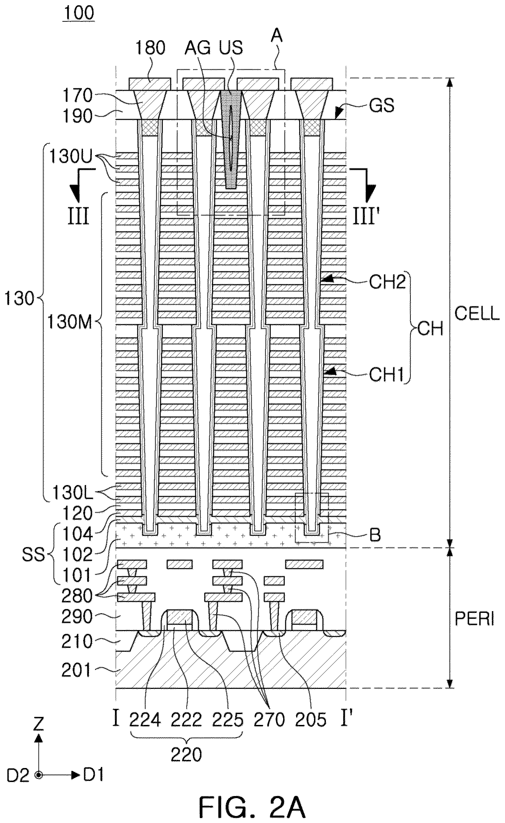

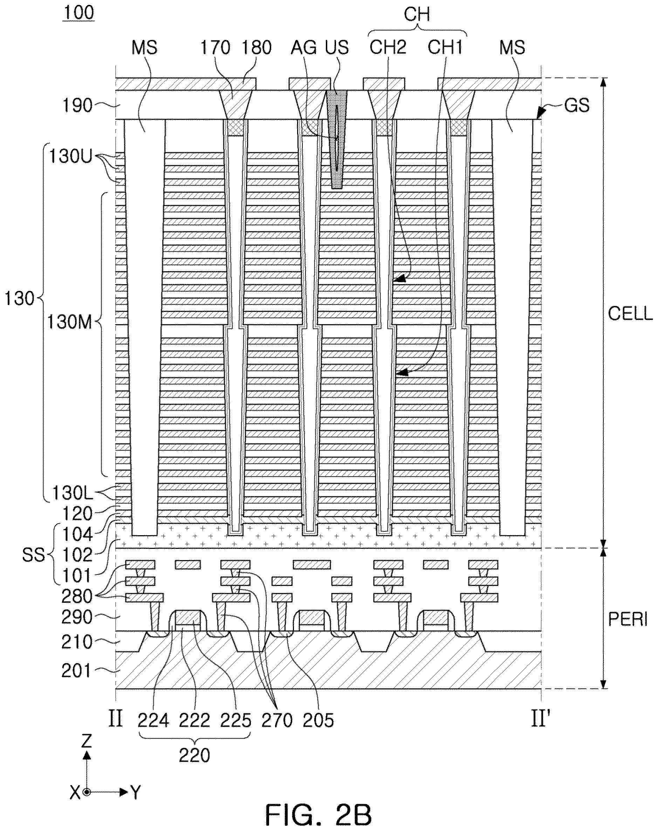

FIGS. 2A and 2B are schematic cross-sectional views of a semiconductor device according to an example embodiment. FIG. 2A is a cross-sectional view taken along the cutting line I-I' of FIG. 1, and FIG. 2B is a cross-sectional view taken along the cutting line II-II' of FIG. 1. In FIG. 2A, D1 is a direction taken along the cutting line I-I', and D2 is a direction, perpendicular to the direction.

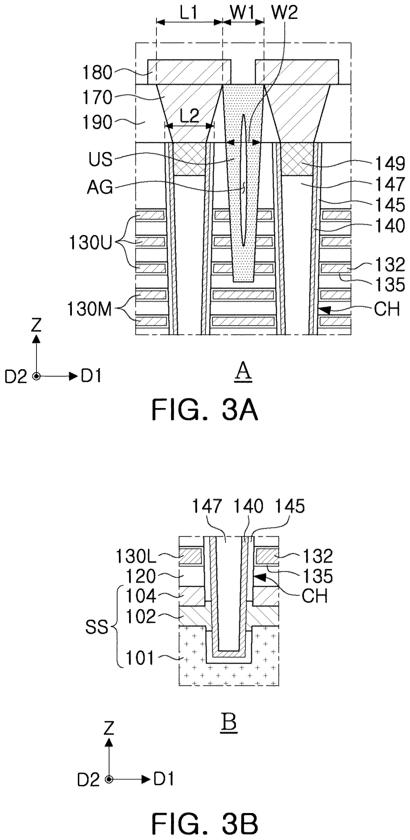

FIGS. 3A and 3B are schematic partially enlarged views of a semiconductor device according to an example embodiment. FIG. 3A is an enlarged view of region 'A' of FIG. 2A, and FIG. 3B is an enlarged view of region 'B' of FIG. 2A.

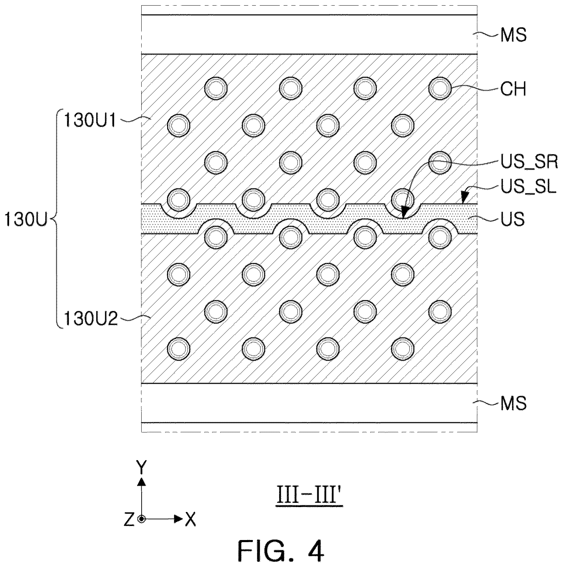

FIG. 4 is a schematic plan view of a semiconductor device according to an example embodiment. FIG. 4 is a plan view taken in the plane of line III-III' of FIG. 2A.

Referring to FIGS. 1 to 4, a semiconductor device 100 may include a peripheral circuit region PERI, which is a first semiconductor structure including a substrate 201, and a memory cell region CELL, which is a second semiconductor structure including a plate layer 101. The memory cell region CELL may be disposed on the peripheral circuit region PERI. In some example embodiments, on the contrary, the memory cell region CELL may be disposed below the peripheral circuit region PERI.

The peripheral circuit region PERI may include a substrate 201, impurity regions 205 and device isolation layers 210 in the substrate 201, circuit elements 220 disposed on the substrate 201, a peripheral region insulating layer 290, circuit contact plugs 270, and circuit interconnections 280.

The substrate 201 may have an upper surface extending in an X-direction and a Y-direction. An active region may be defined on the substrate 201 by the device isolation layers 210. Impurity regions 205 including impurities may be disposed in a portion of the active region. The substrate 201 may include a semiconductor material, such as a group IV semiconductor, a group III-V compound semiconductor, or a group II-VI compound semiconductor. The substrate 201 may be provided as a bulk wafer or an epitaxial layer.

The circuit elements 220 may include planar transistors. Each circuit element 220 may include a circuit gate dielectric layer 222, a spacer layer 224, and a circuit gate electrode 225. Impurity regions 205 may be disposed as source/drain regions in the substrate 201 on both sides of the circuit gate electrode 225.

The peripheral region insulating layer 290 may be disposed on the circuit element 220 on the substrate 201. The peripheral region insulating layer 290 may include a plurality of insulating layers formed in different process operations. The peripheral region insulating layer 290 may be formed of an insulating material.

The circuit contact plugs 270 and the circuit interconnections 280 may form a circuit interconnection structure electrically connected to the circuit elements 220 and the impurity regions 205. The circuit contact plugs 270 may have a cylindrical, or substantially cylindrical (e.g. frusto-conical) shape, and the circuit interconnections 280 may have a line shape. An electrical signal may be applied to the circuit element 220 through the circuit contact plugs 270 and the circuit interconnections 280. In a region not illustrated, the circuit contact plugs 270 may also be connected to the circuit gate electrode 225. The circuit interconnections 280 may be connected to the circuit contact plugs 270 and may be arranged in a plurality of layers. The circuit contact plugs 270 and the circuit interconnections 280 may include a conductive material, for example, tungsten (W), copper (Cu), or aluminum (Al), and may further include a diffusion barrier. In some example embodiments, the number of layers of the circuit contact plugs 270 and the circuit interconnections 280 may vary.

The memory cell region CELL may include a source structure SS, gate electrodes 130 stacked on the source structure SS, interlayer insulating layers 120 alternately stacked with gate electrodes 130 to form a stack structure GS, channel structures CH disposed to penetrate through the gate electrodes 130, first separation regions MS extending by penetrating through the gate electrodes 130, a cell region insulating layer 190 on the channel structures CH, studs 170 respectively connected to the channel structures CH, a second separation region US penetrating through upper gate electrodes 130U of the gate electrodes 130 between the studs 170, and bit lines 180 on studs 170.

The source structure SS may include a plate layer 101, a first horizontal conductive layer 102, and a second horizontal conductive layer 104, which are sequentially stacked. However, in example embodiments, the number of conductive layers forming the source structure SS may vary.

The plate layer 101 has a shape of a plate and may function as at least a portion of a common source line of the semiconductor device 100. The plate layer 101 may have an upper surface extending in the X-direction and the Y-direction. The plate layer 101 may include a conductive material. For example, the plate layer 101 may include a semiconductor material, such as a group IV semiconductor, a group III-V compound semiconductor, or a group II-VI compound semiconductor. For example, the group IV semiconductor may include silicon, germanium, or silicon-germanium. The plate layer 101 may further include impurities. The plate layer 101 may be provided as a polycrystalline semiconductor layer such as a polycrystalline silicon layer or an epitaxial layer.

The first and second horizontal conductive layers 102 and 104 may be sequentially stacked and disposed on an upper surface of the plate layer 101. The first horizontal conductive layer 102 may function as a portion of a common source line of the semiconductor device 100, for example, may function as a common source line together with the plate layer 101. As illustrated in FIG. 3B, the first horizontal conductive layer 102 may be directly connected to the channel layer 140 around the channel layer 140.

The first and second horizontal conductive layers 102 and 104 may include a semiconductor material, for example, polycrystalline silicon. In this case, at least the first horizontal conductive layer 102 may be a layer doped with impurities of the same conductivity type as the plate layer 101, and the second horizontal conductive layer 104 may be a doped layer or a layer including impurities diffused from the first horizontal conductive layer 102.

The gate electrodes 130 may be vertically spaced apart from each other and stacked on the plate layer 101 to form a stack structure GS together with the interlayer insulating layers 120. The stack structure GS may include vertically stacked lower and upper stacked structures. However, according to some example embodiments, the stack structure GS may be formed of a single stack structure.

The gate electrodes 130 may include a lower gate electrode 130L forming gates of a ground selection transistor, memory gate electrodes 130M forming a plurality of memory cells, and upper gate electrodes 130U forming gates of string selection transistors. The number of memory gate electrodes 130M forming memory cells may be determined depending on the capacitance of the semiconductor device 100. The upper gate electrode 130U and the lower gate electrode 130L may also be referred to as an upper selection gate electrode and a lower selection gate electrode, respectively. According to some example embodiments, there may be one to four or more upper and lower gate electrodes 130U and 130L, respectively, and the upper and lower gate electrodes 130U and 130L may have structures identical to or different from the memory gate electrodes 130M. In some example embodiments, gate electrodes 130 may further include a gate electrode disposed on one side of the upper gate electrodes 130U and/or the lower gate electrode 130L and forming an erase transistor used in an erase operation using a gate induced leakage current (GIDL) phenomenon. Additionally, some of the gate electrodes 130, for example, memory gate electrodes 130M adjacent to the upper or lower gate electrodes 130U and 130L, may be dummy gate electrodes.

The gate electrodes 130 may entirely include the same material. The gate electrodes 130 may include a first conductive layer 132 and a second conductive layer 135, as illustrated in FIGS. 3A and 3B. The second conductive layer 135 may surround an upper surface, a lower surface and side surfaces of the first conductive layer 132. The channel structures CH may be in contact with the second conductive layers 135, and the second separation region US may be in contact with the first and second conductive layers 132 and 135. The first separation regions MS may also be in contact with the first and second conductive layers 132 and 135. In the gate electrodes 130, the second conductive layers 135 may cover the side surfaces of the first conductive layers 132 in regions in contact with the channel structures CH, and the side surfaces of the first conductive layers 132 may be exposed from the second conductive layers 135 in regions in contact with the first and second separation regions MS and US.

The first conductive layer 132 may include a metal material, such as tungsten (W) or molybdenum (Mo). According to an example embodiment, the first conductive layer 132 may include polycrystalline silicon or a metal silicide material. The second conductive layer 135 may include tungsten nitride (WN), tantalum nitride (TaN), titanium nitride (TiN), or a combination thereof.

The interlayer insulating layers 120 may be alternately arranged with the gate electrodes 130. Similar to the gate electrodes 130, the interlayer insulating layers 120 may also be spaced apart from each other in a direction perpendicular to an upper surface of the plate layer 101. Some of the interlayer insulating layers 120 may have different thicknesses. For example, the interlayer insulating layer 120 disposed adjacently to a region in which the first channel structure CH1 and the second channel structure CH2 are connected and the interlayer insulating layer 120 on an uppermost upper gate electrode 130U may have a relatively large thickness.

The interlayer insulating layers 120 may include an insulating material such as silicon oxide or silicon nitride. In example embodiments, the thickness of each of the interlayer insulating layers 120 may be variously changed.

The channel structures CH may extend in the Z-direction by penetrating through the stack structure GS and may be connected to the plate layer 101. Each of the channel structures CH may form one memory cell string and may be arranged in rows and columns on the plate layer 101 to be spaced apart from each other. As illustrated in FIG. 1, the channel structures CH may be disposed to form a grid pattern in an X-Y plane or may be arranged in a zigzag shape in one direction. The channel structures CH may have a pillar shape and may have inclined side surfaces that become narrower as they approach the plate layer 101. The channel structures CH may be spaced apart from the second separation region US, and each of the channel structures CH may have a complete shape in which the channel layer 140 is not cut.

The channel structures CH may include first and second channel structures CH1 and CH2 that are vertically stacked. The channel structures CH may have a shape in which the first channel structures CH1 and the second channel structures CH2 are connected, and may have a bent portion due to a difference in width in a connection region. However, according to example embodiments, the number of channel structures stacked in the Z-direction may be variously changed.

Each of the channel structures CH may include a channel layer 140, a gate dielectric layer 145, a channel buried insulating layer 147, and a channel pad 149 disposed in a channel hole, as illustrated in FIGS. 3A and 3B. The channel layer 140 may be formed in an annular shape surrounding the internal channel buried insulating layer 147, but according to an example embodiment, the channel layer 140 may have a pillar shape such as a cylinder or a prism without the channel buried insulating layer 147. The channel layer 140 may be connected to the first horizontal conductive layer 102 in a lower end thereof. The channel layer 140 may include a semiconductor material such as polycrystalline silicon or single crystalline silicon.

The gate dielectric layer 145 may be disposed between the gate electrodes 130 and the channel layer 140. Although not specifically illustrated, the gate dielectric layer 145 may include a tunneling layer, a charge storage layer, and a blocking layer sequentially stacked from the channel layer 140. The tunneling layer may tunnel charges into the charge storage layer and may include, for example, silicon oxide (SiO₂), silicon nitride (Si₃N₄), silicon oxynitride (SiON), or a combination thereof. The charge storage layer may be a charge trap layer or a floating gate conductive layer. The blocking layer may include silicon oxide (SiO₂), silicon nitride (Si₃N₄), silicon oxynitride (SiON), a high-x dielectric material, or a combination thereof. In some example embodiments, at least a portion of the gate dielectric layer 145 may extend in a horizontal direction along the gate electrodes 130.

The channel pad 149 may be disposed only on an upper end of the upper channel structure CH2. The channel pad 149 may be disposed to fill an interior of the channel layer 140 in an upper end thereof. A lower surface of the channel pad 149 may be disposed on a higher level than an uppermost surface of the gate electrodes 130. The channel pad 149 may include, for example, doped polycrystalline silicon.

The channel layer 140, the gate dielectric layer 145, and the channel buried insulating layer 147 may be continuous between the first channel structure CH1 and the second channel structure CH2.

The first separation regions MS may be disposed to extend in the X-direction by penetrating through the stack structure GS. As illustrated in FIG. 1, the first separation regions MS may be disposed in parallel with each other. As illustrated in FIG. 2B, the first separation regions MS may penetrate through the stack structure GS, further penetrate through the first and second horizontal conductive layers 102 and 104 below, and be connected to the plate layer 101. The first separation regions MS may have a shape in which a width thereof decreases toward the plate layer 101 due to a high aspect ratio.

Upper surfaces of the first separation regions MS may be disposed on a lower level than upper surfaces of the studs 170, and may be disposed on substantially the same level as upper surfaces of the channel structures CH. The upper surfaces of the first separation regions MS may be coplanar with the upper surfaces of the channel structures CH. However, in some example embodiments, the upper surfaces of the first separation regions MS may be disposed on a lower level than the upper surfaces of the studs 170 and may be disposed on a higher level than the upper surfaces of the channel structures CH. The first separation regions MS may include an insulating material, and may include, for example, silicon oxide, silicon nitride, or silicon oxynitride.

The cell region insulating layer 190 may be disposed on the stack structure GS. The cell region insulating layer 190 may cover the upper surfaces of the channel structures CH and the upper surfaces of the first separation regions MS. The cell region insulating layer 190 may be formed of an insulating material, each of which may be formed of a plurality of insulating layers.

The studs 170 may be physically and electrically connected to the channel structures CH, respectively, on the channel structures CH. The studs 170 may penetrate through the cell region insulating layer 190 and may be connected to the channel pads 149 of the channel structures CH, respectively. The studs 170 may electrically connect the channel structures CH and the bit lines 180. In some example embodiments, the studs 170 may be disposed to partially recess the channel pads 149.

The studs 170 may have a cylindrical shape and may have inclined side surfaces so that a width thereof decreases toward the channel structures CH (e.g. they may have a frusto-conical shape). In each stud 170, a diameter of an upper surface thereof may be greater than a diameter of a lower surface thereof. A first diameter L1 of the upper surface of the stud 170 may be larger than a second diameter L2 of the upper surface of the channel structure CH. However, in some example embodiments, the first diameter L1 may be the same as the second diameter L2.

In an example embodiment, the studs 170 may be aligned so that central axes thereof coincide with central axes of the channel structures CH. For example, the central axis of the studs 170 in a vertical direction may substantially coincide with the central axis of the channel structures CH in the vertical direction. As illustrated in FIG. 1, the centers of the studs 170 and the channel structures CH may coincide in a plan view.

The studs 170 may include a conductive material, for example, tungsten (W), aluminum (Al), ruthenium (Ru), molybdenum (Mo), copper (Cu), or the like. According to example embodiments, the studs 170 may include the same material as the gate electrodes 130 or a different material from the gate electrodes 130. When the studs 170 include the same material as the gate electrodes 130, the studs 170 may be formed by forming sacrificial layers and then replacing the same.

As illustrated in FIG. 1, the second separation region US may extend in the X-direction between adjacent first separation regions MS, and may penetrate through the upper gate electrodes 130U among the gate electrodes 130. The second separation region US may be disposed between the studs 170. For example, the second separation region US may extend along two adjacent rows in the Y-direction, among the rows of the studs 170 in the X-direction. The second separation region US may overlap the studs 170 of the two rows in the X-direction. The second separation region US may surround a portion of each of the studs 170 in the two rows. For example, the second separation region US may surround each of the two rows of studs 170 in a semicircle or similar shape (for example a part of a circle greater or less than a semicircle) in a plan view. In example embodiments, a ratio of a portion surrounded by the second separation region US on an external peripheral surface of each of the studs 170 may be variously changed.

The side surfaces of second separation region US may include straight portions US_SL extending in a straight line in the X-direction and round portions US_ SR surrounding the studs 170 and the channel structures CH, in a plan view. On each of the side surfaces of the second separation region US, the straight portions US_SL and the round portions US_SR may be alternately arranged in the X-direction.

The upper surface of the second separation region US may be disposed on substantially the same level as the upper surfaces of the studs 170, and may be substantially coplanar with the upper surfaces of the studs 170. The second separation region US may be in contact with at least one of the two rows of studs 170 on an upper surface thereof or an edge of an upper end thereof. The second separation region US may have an inclined side surface to narrow a width thereof toward the plate layer 101. However, a degree of inclination of the side surface may vary in example embodiments, and in some example embodiments, the side surface may be perpendicular to an upper surface of the plate layer 101.

The second separation region US may be horizontally spaced apart from the stud 170 in at least a portion of a region below the upper surface. The second separation region US may be horizontally spaced apart from adjacent channel structures CH. The second separation region US may not overlap the channel structures CH in the Z-direction. A portion of each of the upper gate electrodes 130U may be disposed between the second separation region US and the channel structures CH. A lower surface of the second separation region US may be disposed on a lower level than a lower surface of a lowermost upper gate electrode 130U. The lower surface of the second separation region US may be disposed between the lowermost upper gate electrode 130U and the uppermost memory gate electrode 130M. The second separation region US may have a first width W1 on an upper surface thereof. The first width W1 may be, for example, 80 nm or less, for example, in a range from about 30 nm to about 50 nm. The second separation region US may have a second width W2 that is equal to or smaller than the first width W1 on a level corresponding to the upper surface of the channel structures CH.

As illustrated in FIG. 4, the second separation region US may divide each of the upper gate electrodes 130U into first and second sub-gate electrodes 130U1 and 130U2. The first and second sub-gate electrodes 130U1 and 130U2 may be spaced apart from each other in the Y-direction by the second separation region US. The second separation region US may be spaced apart from the channel structures CH by the upper gate electrodes 130U. In some example embodiments, a plurality of second separation regions US may be disposed between a pair of first separation regions MS.

The second separation region US may include an insulating material, for example, a low dielectric constant material having a lower dielectric constant lower than silicon dioxide (SiO₂). The second separation region US may include, for example, silicon oxide, silicon nitride, or silicon oxynitride. The second separation region US may have an air-gap AG therein, in which case a dielectric constant may be further lowered. However, in some example embodiments, the second separation region US may not have an air-gap AG.

In the semiconductor device 100, the second separation region US may be disposed to overlap the channel structures CH in a horizontal direction, and may be self-aligned between the studs 170, thereby simplifying the manufacturing process. For example, the manufacturing process may be simpler and/or more efficient relative to comparative examples in which a SSL-cut structure may extend along a channel structure, but does not extend along a stud on the channel structure. The second separation region US may be spaced apart from the channel structures CH in horizontal direction without partially penetrating through the channel structures CH, thus improving reliability of the semiconductor device 100. For example, reliability may be improved relative to comparative examples in which a SSL-cut structure partially penetrates (i.e. cuts) a channel structure.

The bit lines 180 may form a cell interconnection structure electrically connected to memory cells in the memory cell area CELL. The bit lines 180 may be electrically connected to the channel structures CH through the studs 170. The bit lines 180 may be disposed to extend, for example, in the Y-direction. The bit lines 180 may include a conductive material such as metal (e.g., tungsten (W), copper (Cu), or aluminum (Al)).

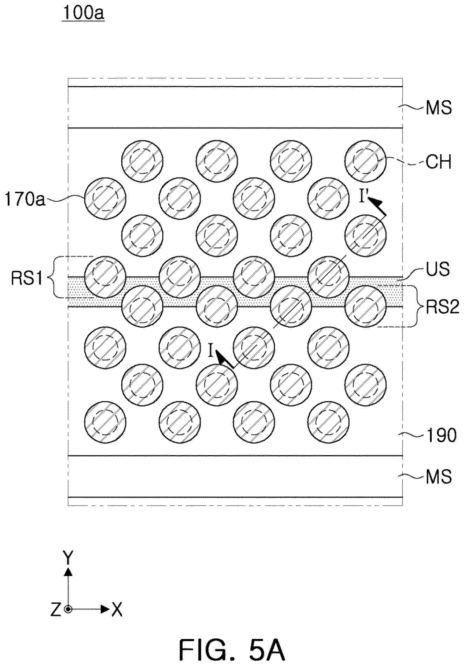

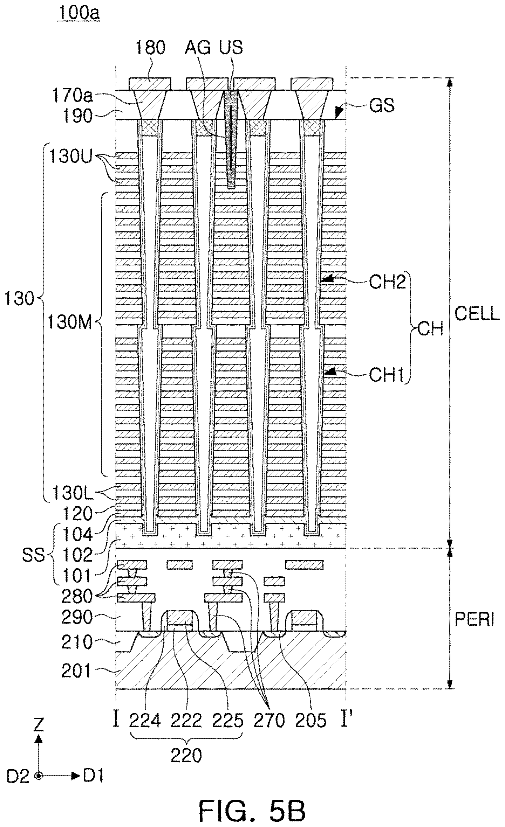

FIGS. 5A and 5B are a schematic plan view and a cross-sectional view of a semiconductor device according to an example embodiment. FIGS. 5A and 5B illustrate regions corresponding to FIGS. 1 and 2A, respectively.

Referring to FIGS. 5A and 5B, in a semiconductor device 100a, an arrangement of studs 170a may be different from those of the example embodiments of FIGS. 1 to 4. For example, the studs 170a of two first and second rows RS 1 and RS2 overlapping the second separation region US in the X-direction may be shifted to face each other. The studs 170a of the first and second rows RS 1 and RS2 may be shifted in the Y-direction toward the second separation region US (i.e. may have a location toward the second separation region US in the Y-direction). A central axis of each of the studs 170a in the first and second rows RS1 and RS2 may not coincide with a central axis of each of the connected channel structures CH. According to this example embodiment, because the second separation region US may be further spaced apart from the channel structures CH in the horizontal direction, the channel structures CH may be more reliably protected during manufacturing of the semiconductor device 100a.

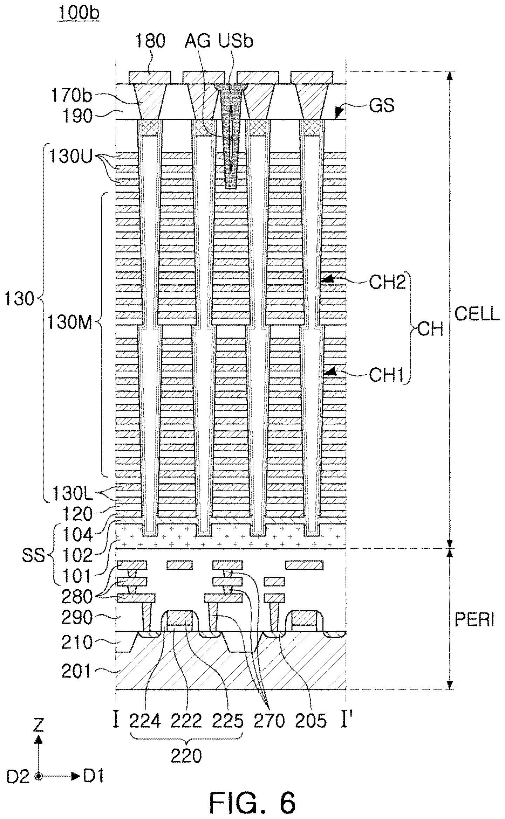

FIG. 6 is a schematic cross-sectional view of a semiconductor device according to an example embodiment. FIG. 6 shows a region corresponding to FIG. 2A.

Referring to FIG. 6, in a semiconductor device 100b, at least one of studs 170b adjacent to a second separation region USb may have a recessed region at an end in contact with the second separation region USb. The studs 170b may have a shape in which ends in contact with the second separation region USb are partially removed from an upper surface and an edge region thereof. The second separation region USb may be expanded and disposed on the recessed regions. In example embodiments, a recess depth and width of the recessed regions may be variously changed.

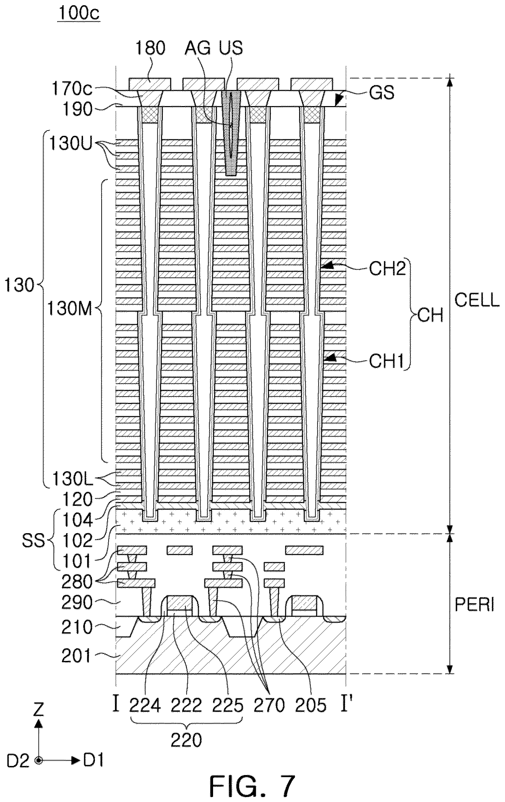

FIG. 7 is a schematic cross-sectional view of a semiconductor device according to an example embodiment. FIG. 7 illustrates an area corresponding to FIG. 2A.

Referring to FIG. 7, in a semiconductor device 100c, an upper surface of the second separation region US may be horizontally spaced apart from upper surfaces of adjacent studs 170. In this example embodiment, the second separation region US may not be in contact with the studs 170. For example, when the studs 170 have a relatively small height, the studs 170 may be spaced apart from the second separation region US. A separation distance between the second separation region US and the stud 170 may be variously changed in example embodiments.

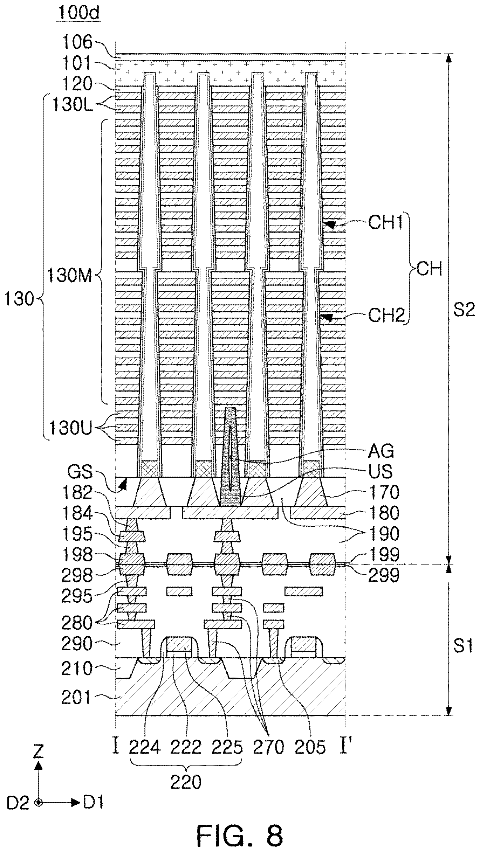

FIG. 8 is a schematic cross-sectional view of a semiconductor device according to an example embodiment. FIG. 8 illustrates a region corresponding to FIG. 2A.

Referring to FIG. 8, a semiconductor device 100d may include a first semiconductor structure S1 and a second semiconductor structure S2 bonded using a wafer bonding method.

The description of a peripheral circuit region PERI described above with reference to FIGS. 1 to 2B may be applied to a first semiconductor structure S1. However, the first semiconductor structure S1 may further include first bonding vias 295, first bonding metal layers 298, and first bonding insulating layer 299, which form a bonding structure. The first bonding vias 295 may be disposed on an upper portion of uppermost circuit interconnections 280, and may be connected to circuit interconnections 280. At least a portion of the first bonding metal layers 298 may be connected to the first bonding vias 295 on the first bonding vias 295. The first bonding metal layers 298 may be connected to second bonding metal layers 198 of a second semiconductor structure S2. The bonding metal layers 298, together with the second bonding metal layers 198, may provide an electrical connection path for bonding the first semiconductor structure S1 and the second semiconductor structure S2. Some of the first bonding metal layers 298 may not be connected to the lower circuit interconnections 280 and may be disposed only for bonding. The first bonding vias 295 and the first bonding metal layers 298 may include a conductive material, for example, copper (Cu). The first bonding insulating layer 299 may be disposed around the first bonding metal layers 298. The first bonding insulating layer 299 may also function as a diffusion prevention layer for the first bonding metal layers 298, and may include, for example, at least one of SiN, SiON, SiCN, SiOC, SiOCN, or SiO.

For the second semiconductor structure S2, unless otherwise specified, the description of a memory cell region CELL described above with reference to FIGS. 1 to 4 may be applied. The second semiconductor structure S2 may further include lower contact plugs 182 and cell interconnections 184, which form a cell interconnection structure, and may further include second bonding vias 195, second bonding metal layers 198, and second bonding insulating layer 199, which form a bonding structure. The second semiconductor structure S2 may further include a passivation layer 106 covering the upper surface of the plate layer 101.

The lower contact plugs 182 may be connected to bit lines 180, and the cell interconnections 184 may be connected to the lower contact plugs 182. However, in example embodiments, the number of layers and arrangement forms of contact plugs and interconnections forming the cell interconnection structure may be variously changed. The lower contact plugs 182 and the cell interconnections 184 may be formed of a conductive material and may include, for example, at least one of tungsten (W), aluminum (Al), or copper (Cu).

The second bonding vias 195 and the second bonding metal layers 198 may be disposed below lowermost cell interconnections 184. The second bonding vias 195 may connect the cell interconnections 184 and the second bonding metal layers 198, and the second bonding metal layers 198 may be bonded to the first bonding metal layers 298 of the first semiconductor structure S1. The second bonding insulating layer 199 may be bonded and connected to the first bonding insulating layer 299 of the first semiconductor structure S 1. The second bonding vias 195 and the second bonding metal layers 198 may include a conductive material, for example, copper (Cu). The second bonding insulating layer 199 may include, for example, at least one of SiO, SiN, SiCN, SiOC, SiON, or SiOCN.

The first and second semiconductor structures S1 and S2 may be bonded by bonding the first bonding metal layers 298 and the second bonding metal layers 198 and bonding the first bonding insulating layer 299 and the second bonding insulating layer 199. The bonding of the first bonding metal layers 298 and the second bonding metal layers 198 may be, for example, copper (Cu)-to-copper (Cu) bonding, and the bonding of the first bonding insulating layer 299 and the second bonding insulating layer 199 may be, for example, dielectric-to-dielectric bonding such as SiCN-to-SiCN bonding. The first and second semiconductor structures S1 and S2 may be bonded by hybrid bonding including copper (Cu)-to-copper (Cu) bonding and dielectric-to-dielectric bonding.

The passivation layer 106 may be disposed on the upper surface of the plate layer 101 and may protect the semiconductor device 100d. The passivation layer 106 may include an insulating material, for example, at least one of silicon oxide, silicon nitride, or silicon carbide, and may be formed of a plurality of insulating layers according to some example embodiments.

In this example embodiment, the second semiconductor structure S2 may not include the first and second horizontal conductive layers 102 and 104 (see FIG. 2A). The channel structures CH may be directly connected to the plate layer 101 with the channel layers 140 (see FIG. 3B) exposed through an upper end thereof. However, the electrical connection form of channel structures CH and a common source line may be changed variously in example embodiments, and the channel structures CH and source structures SS may also have the same structure as the example embodiment of FIG. 2A.

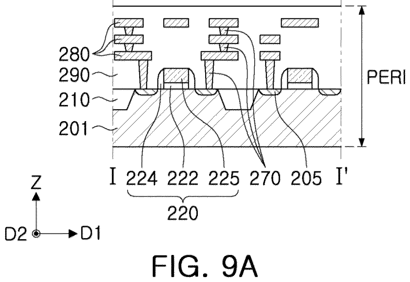

FIGS. 9A to 9I are schematic cross-sectional views for describing a method of manufacturing a semiconductor device according to an example embodiment. Each of FIGS. 9A to 9I illustrates regions corresponding to FIG. 2A.

Referring to FIG. 9A, circuit elements 220, a circuit interconnection structure, and a peripheral region insulating layer 290, forming a peripheral circuit region PERI, may be formed on a substrate 201.

First, device isolation layers 210 may be formed in the substrate 201, and a circuit gate dielectric layer 222 and a circuit gate electrode 225 may be sequentially formed on the substrate 201. The device isolation layers 210 may be formed in, for example, a shallow trench isolation (STI) process. The circuit gate dielectric layer 222 and the circuit gate electrode 225 may be formed using atomic layer deposition (ALD) or chemical vapor deposition (CVD). The circuit gate dielectric layer 222 may be formed of silicon oxide, and the circuit gate electrode 225 may be formed of at least one of polycrystalline silicon or a metal silicide layer, but example embodiments of the present disclosure are not limited thereto. Next, a spacer layer 224 and impurity regions 205 may be formed on both sidewalls of the circuit gate dielectric layer 222 and the circuit gate electrode 225. According to example embodiments, the spacer layer 224 may be formed of a plurality of layers. The impurity regions 205 may be formed in performing an ion implantation process.

Among the circuit interconnection structures, the circuit contact plugs 270 may be formed by forming a portion of the peripheral region insulating layer 290, etching and removing a portion thereof, and then burying a conductive material therein. Circuit interconnections 280 may be formed, for example, by depositing a conductive material and then patterning the conductive material.

The peripheral region insulating layer 290 may be formed of a plurality of insulating layers. The peripheral region insulating layer 290 may be a portion of each operation of forming a circuit interconnection structure. Accordingly, a peripheral circuit region PERI may be formed.

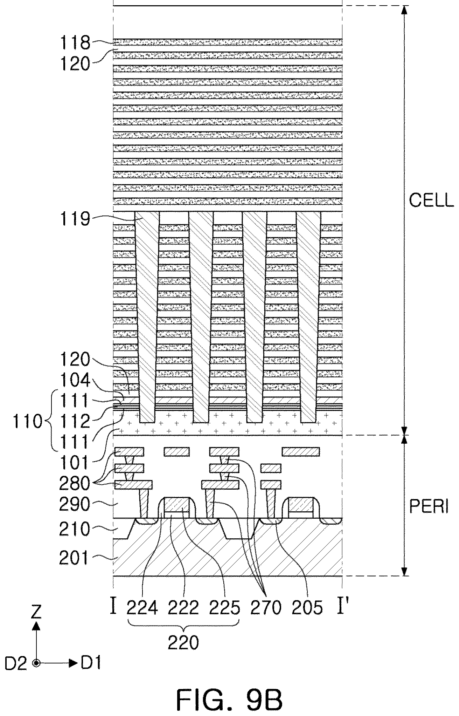

Referring to FIG. 9B, a plate layer 101 provided with a memory cell region CELL, a horizontal sacrificial layer 110, and a second horizontal conductive layer 104 may be formed on the peripheral circuit region PERI, sacrificial insulating layers 118 and interlayer insulating layers 120 may be alternately stacked to form a lower mold structure, and after forming lower channel sacrificial layers 119, an upper mold structure may be formed.

The plate layer 101 may be formed on the peripheral region insulating layer 290. The plate layer 101 may be formed of, for example, polycrystalline silicon and may be formed in a CVD process. Polycrystalline silicon forming the plate layer 101 may include impurities.

First and second horizontal insulating layers 111 and 112 forming the horizontal sacrificial layer 110 may be alternately stacked on the plate layer 101. The horizontal sacrificial layer 110 may be layers replaced with the first horizontal conductive layer 102 of FIG. 2 in a subsequent process. The first horizontal insulating layers 111 may include a material different from that of the second horizontal insulating layer 112. For example, the first horizontal insulating layers 111 may be formed of the same material as the interlayer insulating layers 120, and the second horizontal insulating layer 112 may be formed of the same material as the sacrificial insulating layers 118. The second horizontal conductive layer 104 may be formed on the horizontal sacrificial layer 110.

The lower mold structure may be formed on the second horizontal conductive layer 104 at a height at which the first channel structures CH1 (see FIG. 2A) of the channel structures CH (see FIG. 2A) are disposed.

The sacrificial insulating layers 118 may be a layer replaced as a portion of the gate electrodes 130 (see FIG. 2A) through a subsequent process. The sacrificial insulating layers 118 may be formed of a material different from the interlayer insulating layers 120, and may be formed of a material that has etch selectivity under specific etching conditions with respect to the interlayer insulating layers 120. For example, the interlayer insulating layer 120 may be formed of at least one of silicon oxide or silicon nitride, and the sacrificial insulating layers 118 may be formed of a material different from the interlayer insulating layer 120 selected from silicon, silicon oxide, silicon carbide, and silicon nitride. In some example embodiments, the thicknesses of the interlayer insulating layers 120 may not be the same. The thickness of the interlayer insulating layers 120 and the sacrificial insulating layers 118 and the number of constituting films may be changed variously from those illustrated.

The lower channel sacrificial layers 119 may be formed in positions corresponding to the first channel structures CH1. The lower channel sacrificial layers 119 may be formed by forming holes to penetrate through the lower mold structure, depositing a material forming the lower channel sacrificial layers 119 in the holes, and performing a planarization process. The lower channel sacrificial layers 119 may include, for example, polycrystalline silicon.

The upper mold structure may be formed on the lower mold structure at a height at which the second channel structures CH2 (see FIG. 2A) of the channel structures CH are disposed. The upper mold structure may be formed by alternately stacking sacrificial insulating layers 118 and interlayer insulating layers 120 in the same manner as the lower mold structure.

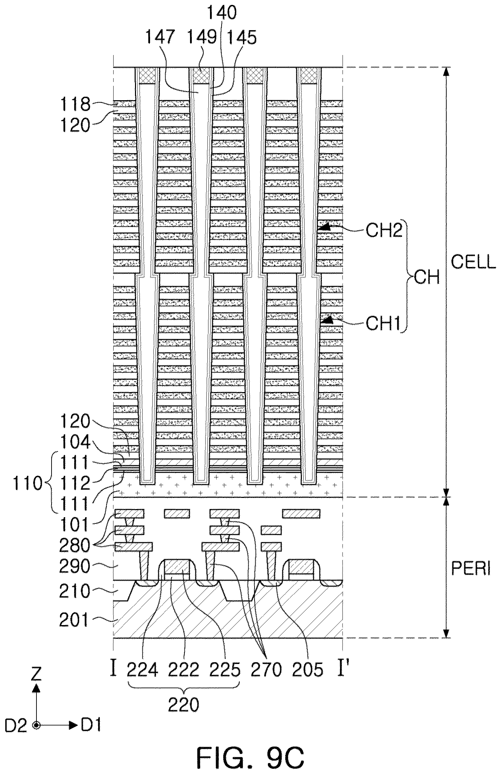

Referring to FIG. 9C, channel structures CH penetrating through the lower mold structure and the upper mold structure may be formed.

Upper channel sacrificial layers penetrating through the upper mold structure may be formed. The upper channel sacrificial layers may be formed in positions corresponding to the upper channel structures CH2. The upper channel sacrificial layers may be formed to be connected to the lower channel sacrificial layers 119, respectively.

The channel structures CH may be formed by removing the lower channel sacrificial layers 119 and the upper channel sacrificial layers to form hole-shaped channel holes, and sequentially depositing at least a portion of the gate dielectric layer 145, the channel layer 140, and the channel buried insulating layer 147 in the channel holes, and forming the channel pad 149.

The gate dielectric layer 145 may be formed to have a uniform thickness using an ALD or CVD process. In this operation, the gate dielectric layer 145 may be formed in whole or in part, and a portion extending perpendicular to the plate layer 101 along the channel structures CH may be formed in this operation. A channel layer 140 may be formed on the gate dielectric layer 145 in the channel holes. The channel buried insulating layer 147 may be formed to fill the channel holes and may be formed of an insulating material. The channel pad 149 may be formed after partially removing the channel buried insulating layer 147. The channel pad 149 may be formed of a conductive material, for example, polycrystalline silicon.

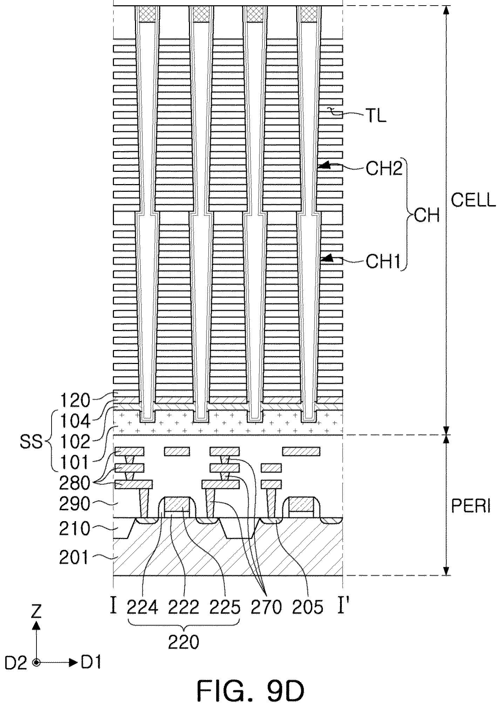

Referring to FIG. 9D, the first horizontal conductive layer 102 may be formed and the sacrificial insulating layers 118 may be removed.

Openings may be formed in positions of the first separation regions MS (see FIG. 1). The openings may be formed to extend to the plate layer 101 by penetrating through the sacrificial insulating layers 118 and the interlayer insulating layers 120. The horizontal sacrificial layer 110 may be selectively removed through the openings, and a portion of the exposed gate dielectric layer 145 may also be removed. The first horizontal conductive layer 102 may be formed by depositing a conductive material in a region in which the horizontal sacrificial layer 110 has been removed.

The sacrificial insulating layers 118 may be removed selectively with respect to the interlayer insulating layers 120, the second horizontal conductive layer 104, and the channel structures CH, using, for example, wet etching. Tunnel portions TL may be formed in regions in which the sacrificial insulating layers 118 have been removed.

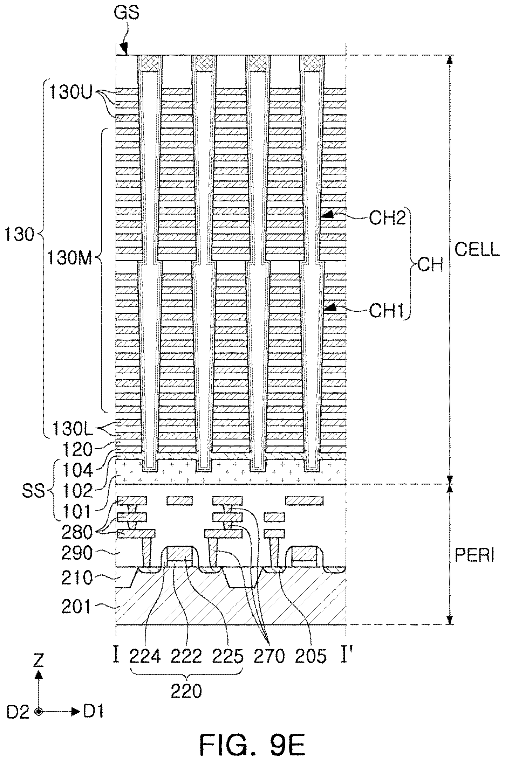

Referring to FIG. 9E, gate electrodes 130 may be formed.

The gate electrodes 130 may be formed by depositing a conductive material on the tunnel portions TL. As illustrated in FIGS. 3A and 3B, the second conductive layers 135 may be formed first, and then the first conductive layers 132 may be formed to fill the tunnel portions TL. In some example embodiments, a portion of the gate dielectric layer 145 may be formed first before forming the second conductive layers 135. After forming the gate electrodes 130, first separation regions MS (see FIG. 2B) may be formed by depositing an insulating material in the openings.

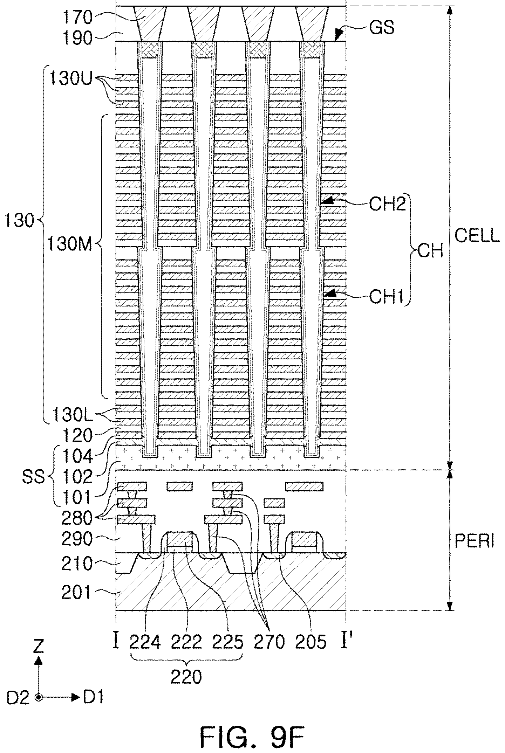

Referring to FIG. 9F, a cell region insulating layer 190 and studs 170 may be formed.

The cell region insulating layer 190 may be formed to cover the upper surfaces of the stack structure GS and the channel structures CH.

The studs 170 may be formed to penetrate through the cell region insulating layer 190 and be connected to the channel structures CH. The studs 170 may include a conductive material different from the gate electrodes 130 so as to have etch selectivity with respect to the gate electrodes 130 in a subsequent process.

In some example embodiments, sacrificial layers may be formed instead of the studs 170 in this operation, and may be replaced with the studs 170 in a subsequent process. In this case, the sacrificial layers may include, for example, aluminum oxide or silicon nitride.

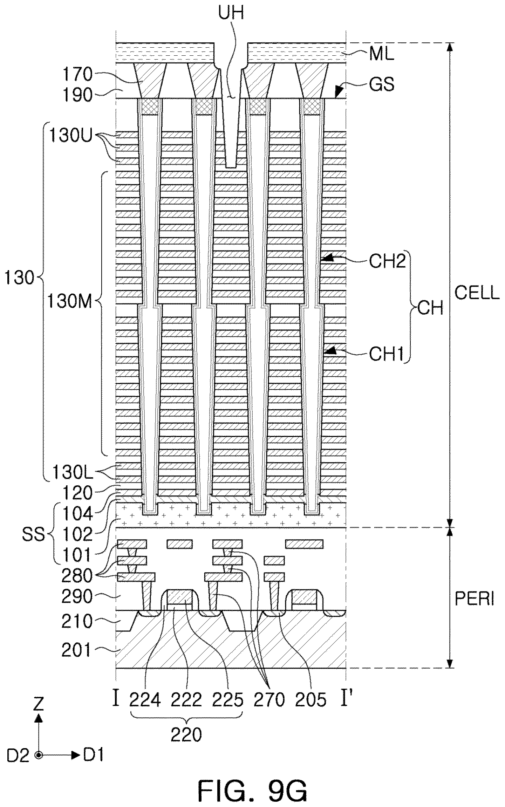

Referring to FIG. 9G, an upper opening UH may be formed to form a second separation region US (see FIG. 2A).

A mask layer ML may be formed to open a region corresponding to the second separation region US. Next, the cell region insulating layer 190 and the stack structure GS exposed between the studs 170 may be partially removed in an etching process. The etching process may be, for example, a dry etching process, and the gate electrodes 130 and the interlayer insulating layers 120 may be selectively etched while reducing or minimizing etching of the studs 170.

The upper opening UH may be formed in the form of a trench across two rows of studs 170, like the second separation region US of FIG. 1. When forming the upper opening UH, the two rows of studs 170 function as masks, so that the upper opening UH may be formed by self-aligning between the studs 170. In this operation, upper ends of the studs 170 adjacent to the upper opening UH may be partially recessed. However, in some example embodiments, the upper ends of the studs 170 may not be recessed in this operation.

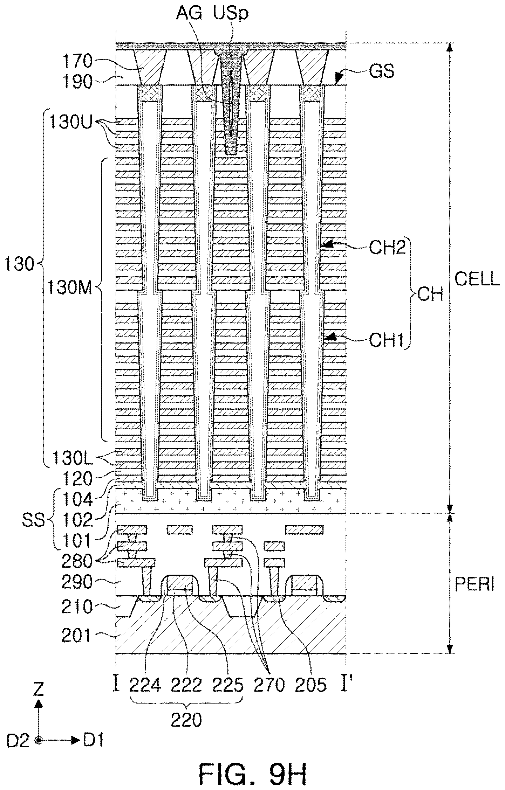

Referring to FIG. 9H, the upper opening UH may be filled with an insulating material to form a preliminary second separation region USp.

The preliminary second separation region USp may include an air-gap AG therein. In some example embodiments, the insulating material may be a low dielectric constant material. The preliminary second separation region USp may have a shape in which a width thereof decreases toward the plate layer 101. However, in some example embodiments, a side surface of the second preliminary separation region USp may be perpendicular to an upper surface of the plate layer 101.

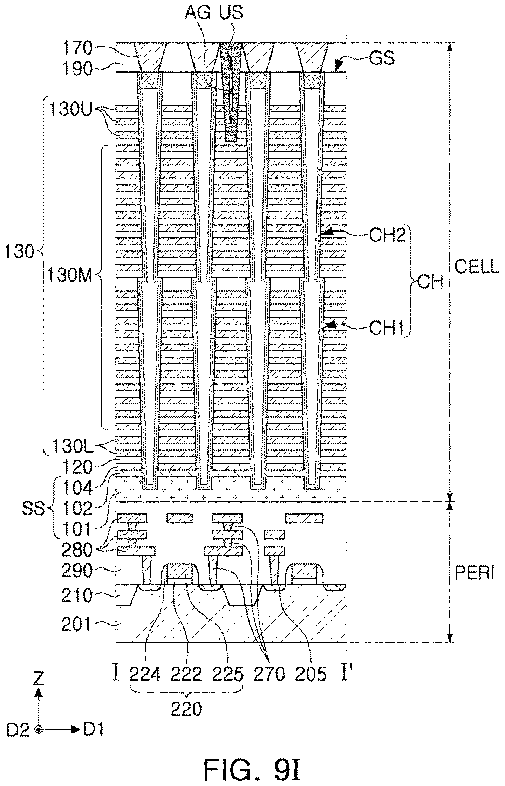

Referring to FIG. 9I, a planarization process may be performed to form the second separation region US.

A planarization process such as chemical mechanical polishing (CMP) may be performed to partially remove the studs 170, the cell region insulating layer 190, and the preliminary second separation region USp, and a second separation region US may be formed. In this operation, regions in which the upper ends of the studs 170 are recessed may also be removed.

In some example embodiments, when sacrificial layers are formed instead of the studs 170 in the operation described above with reference to FIG. 9F, in this operation, after the planarization process, the sacrificial layers may be replaced with a conductive material to form studs 170.

For the example embodiment of FIG. 6, by reducing an amount removed by the planarization process in this operation, the upper ends of the studs 170 may be formed to include recessed regions. For the example embodiment of FIG. 7, by increasing an amount removed by the planarization process in this operation, the upper ends of the studs 170 may be formed to be spaced apart from the second separation region US.

Next, referring to FIG. 2A together, the semiconductor device 100 may be manufactured by forming bit lines 180 on the studs 170.

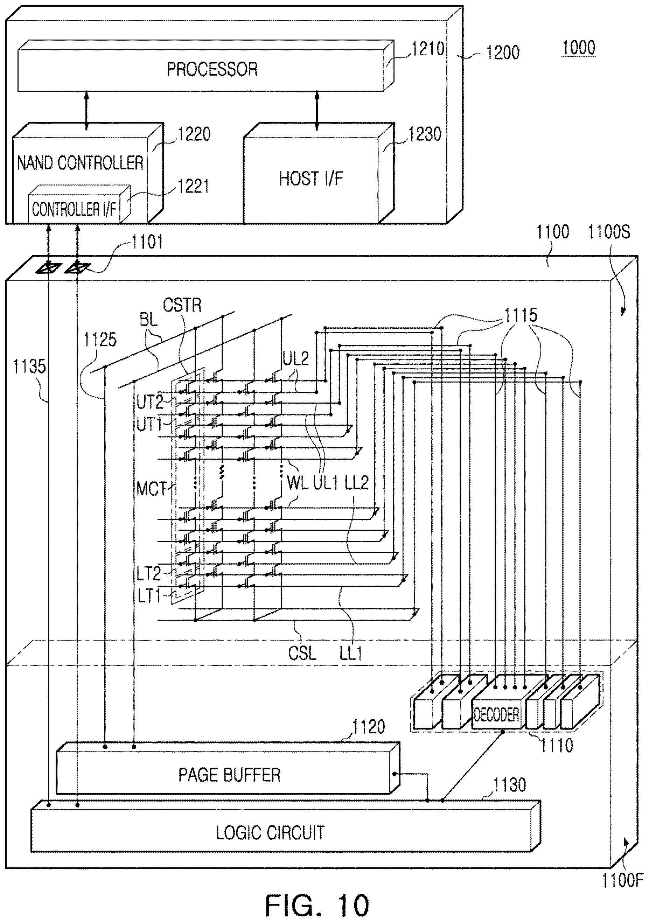

FIG. 10 is a view schematically illustrating a data storage system including a semiconductor device according to an example embodiment.

Referring to FIG. 10, a data storage system 1000 may include a semiconductor device 1100 and a controller 1200 electrically connected to the semiconductor device 1100. The data storage system 1000 may be a storage device including one or a plurality of semiconductor devices 1100 or an electronic device including a storage device. For example, the data storage system 1000 may be a solid state drive device (SSD) device including one or a plurality of semiconductor devices 1100, a universal serial bus (USB) device, a computing system, a medical device, or a communication device.

The semiconductor device 1100 may be a non-volatile memory device, for example, a NAND flash memory device described above with reference to FIGS. 1 to 8. The semiconductor device 1100 may include a first structure 1100F and a second structure 1100S on the first structure 1100F. In example embodiments, the first structure 1100F may be disposed next to the second structure 1100S. The first structure 1100F may be a peripheral circuit structure including a decoder circuit 1110, a page buffer 1120, and a logic circuit 1130. The second structure 1100S may be a memory cell structure including a bit line BL, a common source line CUS_SL, word lines WL, first and second gate upper lines UL1 and UL2, first and second gate lower lines LL1 and LL2, and memory cell strings CSTR between the bit line BL and the common source line CUS_SL.

In the second structure 1100S, each of the memory cell strings CSTR may include lower transistors LT1 and LT2 adjacent to the common source line CUS_SL, upper transistors UT1 and UT2 adjacent to the bit line BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be modified variously according to example embodiments.

In some example embodiments, the upper transistors UT1 and UT2 may include string select transistors, and the lower transistors LT1 and LT2 may include a ground selection transistor. The gate lower lines LL1 and LL2 may be gate electrodes of the lower transistors LT1 and LT2, respectively. The word lines WL may be gate electrodes of the memory cell transistors MCT, and the gate upper lines UL1 and UL2 may be gate electrodes of the upper transistors UT1 and UT2, respectively.

In some example embodiments, the lower transistors LT1 and LT2 may include a lower erase control transistor LT1 and a ground selection transistor LT2 connected in series. The upper transistors UT1 and UT2 may include a string select transistor UT1 and an upper erase control transistor UT2 connected in series. At least one of the lower erase control transistor LT1 and the upper erase control transistor UT2 may be used in an erase operation to erase data stored in the memory cell transistors MCT using a GIDL phenomenon.

The common source line CUS_SL, the first and second gate lower lines LL1 and LL2, the word lines WL, and the first and second gate upper lines UL1 and UL2 may be electrically connected to the decoder circuit 1110 through first interconnections 1115 extending to the second structure 1100S in the first structure 1100F. The bit lines BL may be electrically connected to the page buffer 1120 through second interconnections 1125 extending to the second structure 1100S in the first structure 1100F.

In the first structure 1100F, the decoder circuit 1110 and the page buffer 1120 may perform a control operation on at least one selected memory cell transistor among a plurality of memory cell transistors (MCT). The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through an input/output interconnection 1135 extending to the second structure 1100S in the first structure 1100F.

The controller 1200 may include a processor 1210, a NAND controller 1220, and a host interface 1230. According to some example embodiments, the data storage system 1000 may include a plurality of semiconductor devices 1100, and in this case, the controller 1200 may control the plurality of semiconductor devices 1100.

The processor 1210 may control an overall operation of the data storage system 1000, including the controller 1200. The processor 1210 may operate according to predetermined firmware and may control the NAND controller 1220 to access the semiconductor device 1100. The NAND controller 1220 may include a controller interface 1221 processing communication with the semiconductor device 1100. Through the controller interface 1221, control commands for controlling the semiconductor device 1100, data to be written to the memory cell transistors (MCT) of the semiconductor device 1100, and data to be read from the memory cell transistors (MCT) of the semiconductor device 1100, and the like, may be transmitted. The host interface 1230 may provide a communication function between the data storage system 1000 and an external host. When receiving a control command from an external host through the host interface 1230, the processor 1210 may control the semiconductor device 1100 in response to control commands.

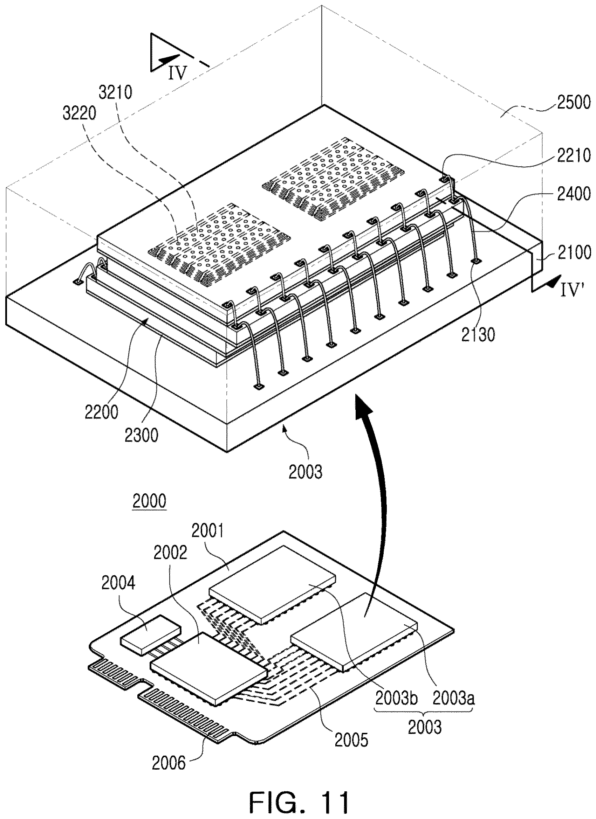

FIG. 11 is a perspective view schematically illustrating a data storage system including a semiconductor device according to an example embodiment.

Referring to FIG. 11, a data storage system 2000 according to an example embodiment of the present disclosure may include a main board 2001, a controller 2002 mounted on the main board 2001, one or more semiconductor packages 2003, and DRAM 2004. The semiconductor package 2003 and the DRAM 2004 may be connected to the controller 2002 through interconnection patterns 2005 formed on the main board 2001.

The main board 2001 may include a connector 2006 including a plurality of pins coupled to an external host. The number and arrangement of the plurality of pins in the connector 2006 may vary depending on a communication interface between the data storage system 2000 and the external host. In some example embodiments, the data storage system 2000 may communicate with an external host according to any one of the interfaces, such as, Universal Serial Bus (USB), Peripheral Component Interconnect Express (PCI-Express), Serial Advanced Technology Attachment (SATA), M-Phy for Universal Flash Storage (UFS). In some example embodiments, the data storage system 2000 may operate with power supplied from an external host through the connector 2006. The data storage system 2000 may further include a power management integrated circuit (PMIC) distributing power supplied from the external host to the controller 2002 and the semiconductor package 2003.

The controller 2002 may record data in the semiconductor package 2003 or read data from the semiconductor package 2003, and may improve operating speed of data storage system 2000.

The DRAM 2004 may be a buffer memory to alleviate a speed difference between the semiconductor package 2003, which is a data storage space, and an external host. The DRAM 2004 included in the data storage system 2000 may operate as a type of cache memory and may provide a space for temporarily storing data during control operations for the semiconductor package 2003. When the data storage system 2000 includes the DRAM 2004, the controller 2002 may further include a DRAM controller for controlling the DRAM 2004 in addition to a NAND controller for controlling the semiconductor package 2003.

The semiconductor package 2003 may include first and second semiconductor packages 2003a and 2003b spaced apart from each other. Each of the first and second semiconductor packages 2003a and 2003b may semiconductor packages including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of each of the semiconductor chips 2200, a connection structure 2400 electrically connecting the semiconductor chips 2200 and the package substrate 2100, and a molding layer 2500 covering the semiconductor chips 2200 and the connection structure 2400 on the package substrate 2100.

The package substrate 2100 may be a printed circuit board including package upper pads 2130. Each of the semiconductor chips 2200 may include an input/output pad 2210. The input/output pad 2210 may correspond to the input/output pad 1101 of FIG. 10. Each of the semiconductor chips 2200 may include gate stack structures 3210 and channel structures 3220. Each of the semiconductor chips 2200 may include the semiconductor device described above with reference to FIGS. 1 to 8.

In some example embodiments, the connection structure 2400 may be a bonding wire electrically connecting the input/output pad 2210 and the package upper pads 2130. Accordingly, in each of the first and second semiconductor packages 2003a and 2003b, the semiconductor chips 2200 may be electrically connected to each other using a bonding wire method, and may be electrically connected to the package upper pads 2130 of the package substrate 2100. According to some example embodiments, in each of the first and second semiconductor packages 2003a and 2003b, the semiconductor chips 2200 may be electrically connected to each other by a connection structure including a through-silicon via (TSV), instead of a bonding wire type connection structure 2400.

In some example embodiments, the controller 2002 and the semiconductor chips 2200 may be included in one package. In an example embodiment, the controller 2002 and the semiconductor chips 2200 may be mounted on a separate interposer substrate different from the main board 2001, and the controller 2002 and the semiconductor chips 2200 may be connected to each other through an interconnection formed on the interposer substrate.

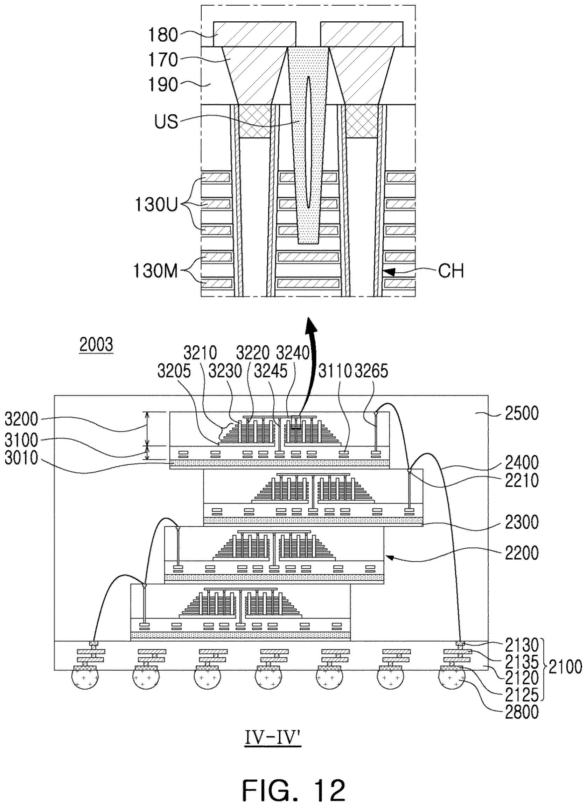

FIG. 12 is a cross-sectional view schematically illustrating a semiconductor package according to an example embodiment. FIG. 12 illustrates an example embodiment of the semiconductor package 2003 of FIG. 11 and conceptually illustrates a region in which the semiconductor package 2003 of FIG. 11 is cut along the cutting line IV-IV'.

Referring to FIG. 12, in the semiconductor package 2003, the package substrate 2100 may be a printed circuit board. The package substrate 2100 may include a package substrate body portion 2120, package upper pads 2130 disposed on an upper surface of the package substrate body portion 2120, lower pads 2125 disposed on a lower surface of the package substrate body portion 2120 or exposed through the lower surface thereof, and internal interconnections 2135 electrically connecting the package upper pads 2130 and the lower pads 2125 in the package substrate body portion 2120. The lower pads 2125 may be connected to the interconnection patterns 2005 of the main board 2001 of the data storage system 2000 as illustrated in FIG. 11 through conductive connectors 2800.

Each of the semiconductor chips 2200 may include a semiconductor substrate 3010 and a first structure 3100 and a second structure 3200 that are sequentially stacked on the semiconductor substrate 3010. The first structure 3100 may include a peripheral circuit region including peripheral interconnections 3110. The second structure 3200 may include a common source line 3205, a gate stack structure 3210 on the common source line 3205, channel structures 3220 and isolation structures 3230 penetrating through the gate stack structure 3210, and bit lines 3240 electrically connected to the channel structures 3220. As described above with reference to FIGS. 1 to 8, in each of the semiconductor chips 2200, the second separation region US may be disposed between the studs 170, and an upper surface of the second separation region US may be coplanar with upper surfaces of the studs 170.

Each of the semiconductor chips 2200 may include a through-interconnection 3245 electrically connected to the peripheral interconnections 3110 of the first structure 3100 and extending into the second structure 3200. The through-interconnection 3245 may penetrate through the gate stack structure 3210, and may be disposed further outside the gate stack structure 3210. Each of the semiconductor chips 2200 may further include an input/output connection interconnection 3265 electrically connected to the peripheral interconnections 3110 of the first structure 3100 and extending into the second structure 3200, and an input/output pad 2210 electrically connected to the input/output connection interconnection 3265.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

The present disclosure is not limited to the above-described example embodiments and the accompanying drawings but is defined by the appended claims. Therefore, those of ordinary skill in the art may make various replacements, modifications, or changes without departing from the scope of the present disclosure defined by the appended claims, and these replacements, modifications, or changes should be construed as being included in the scope of the present disclosure.

Examples are set out in the following clauses:
1. A semiconductor device, comprising:
   a first semiconductor structure including a substrate, circuit elements on the substrate, and circuit interconnections on the circuit elements; and
   a second semiconductor structure on the first semiconductor structure,
   wherein the second semiconductor structure includes
      a plate layer,
      gate electrodes stacked on the plate layer and spaced apart from each other in a first direction perpendicular to an upper surface of the plate layer, the gate electrodes including a lower gate electrode, memory gate electrodes, and an upper gate electrode sequentially stacked on the plate layer,
      interlayer insulating layers alternately stacked with the gate electrodes,
      channel structures in channel holes penetrating through a stack structure of the gate electrodes and the interlayer insulating layers,
      a cell region insulating layer on the channel structures,
      studs penetrating through the cell region insulating layer and connected to the channel structures, respectively, the studs being in rows in a second direction perpendicular to the first direction,
      first separation regions penetrating through the stack structure and extending in the second direction, and
      a second separation region penetrating through the cell region insulating layer and the upper gate electrode, the second separation region extending in the second direction and being between two adjacent rows of the studs,
   wherein the second separation region overlaps the two adjacent rows of the studs in the second direction, and
   wherein an upper surface of the second separation region is coplanar with upper surfaces of the studs.
2. The semiconductor device of clause 1, wherein side surfaces of the second separation region have round portions corresponding to the studs.
3. The semiconductor device of clause 1 or clause 2, wherein the second separation region is in contact with at least one of the studs of the two adjacent rows.
4. The semiconductor device of clause 3, wherein the at least one of the studs of the two adjacent rows has a recessed region from an upper end thereof at a region in contact with the second separation region.
5. The semiconductor device of any preceding clause, wherein the two adjacent rows of the studs are arranged so that central axes of the studs are shifted toward the second separation region from central axes of the channel structures, respectively.
6. The semiconductor device of any preceding clause, wherein diameters of the studs are equal to or larger than a diameter of the channel structures.
7. The semiconductor device of any preceding clause, wherein the second separation region is spaced apart from the channel structures in a horizontal direction.
8. The semiconductor device of clause 7, wherein a portion of the upper gate electrode is between the second separation region and the channel structures.
9. The semiconductor device of any preceding clause, wherein the upper gate electrode includes a first conductive layer and a second conductive layer covering an upper surface and a lower surface of the first conductive layer, and
   wherein the second separation region is in contact with both the first conductive layer and the second conductive layer.
10. The semiconductor device of clause 9, wherein
   the second conductive layer covers side surfaces of the first conductive layer in regions in which the second conductive layer is in contact with the channel structures, and
   the second conductive layer exposes the first conductive layer in a region in which the second conductive layer is in contact with the second separation region.
11. The semiconductor device of any preceding clause, wherein the studs include a different material from the gate electrodes.
12. The semiconductor device of any preceding clause, wherein the second separation region includes an air-gap therein.
13. The semiconductor device of any preceding clause, wherein each of the studs has an inclined side surface to narrow a width thereof toward the channel structures.
14. The semiconductor device of any preceding clause, wherein
   each of the channel structures includes a channel layer extending in the first direction and a channel pad filling an interior of the channel layer at an upper end of each of the channel structure,
   a lower surface of the channel pad is on a higher level than an uppermost surface of the gate electrodes, and
   each of the studs is connected to the channel pad of a corresponding one of the channel structures.
15. A semiconductor device, comprising:
   a plate layer;
   gate electrodes stacked on the plate layer and spaced apart from each other in a first direction perpendicular to an upper surface of the plate layer, the gate electrodes including a lower gate electrode, memory gate electrodes, and an upper gate electrode sequentially stacked from the plate layer;
   channel structures in channel holes penetrating through the gate electrodes;
   a cell region insulating layer on the channel structures;
   studs penetrating through the cell region insulating layer and connected to the channel structures, respectively;
   first separation regions penetrating through the gate electrodes and extending in a second direction perpendicular to the first direction; and
   a second separation region penetrating through the upper gate electrode, extending in the second direction and being between the studs,
   wherein side surfaces of the second separation region include round portions surrounding the studs and straight portions extending in the second direction between the round portions,
   wherein each of the gate electrodes includes a first conductive layer and a second conductive layer covering an upper surface and a lower surface of the first conductive layer, and
   wherein the second separation region is in contact with the first conductive layer and the second conductive layer of the upper gate electrode.
16. The semiconductor device of clause 15, wherein an upper surface of the second separation region is on a same level as upper surfaces of the studs.
17. The semiconductor device of clause 15 or clause 16, wherein the studs adjacent to the second separation region are arranged so that central axes of the studs are shifted toward the second separation region from central axes of the channel structures, respectively.
18. The semiconductor device of any of clauses 15 to 17, wherein upper surfaces of the first separation regions are on a lower level than upper surfaces of the studs.
19. A data storage system, comprising:
   a semiconductor storage device including a first semiconductor structure including circuit elements, a second semiconductor structure on a surface of the first semiconductor structure, and an input/output pad electrically connected to the circuit elements; and
   a controller electrically connected to the semiconductor storage device through the input/output pad and configured to control the semiconductor storage device,
   wherein the second semiconductor structure includes
      a plate layer,
      gate electrodes stacked on the plate layer and spaced apart from each other in a first direction perpendicular to an upper surface of the plate layer, the gate electrodes including a lower gate electrode, memory gate electrodes, and an upper gate electrode sequentially stacked from the plate layer,
      channel structures in channel holes penetrating through the gate electrodes,
      a cell region insulating layer on the channel structures,
      studs penetrating through the cell region insulating layer and connected to the channel structures, respectively,
      first separation regions penetrating through the gate electrodes and extending in a second direction perpendicular to the first direction, and
      a second separation region penetrating through the cell region insulating layer and the upper gate electrode, the second separation region extending in the second direction and being between the studs, and
   wherein the second separation region does not overlap the channel structures in the first direction and overlaps some of the studs in the second direction.
20. The data storage system of clause 19, wherein an upper surface of the second separation region is coplanar with upper surfaces of the studs.

## Claims

1. A semiconductor device, comprising:
a first semiconductor structure including a substrate, circuit elements on the substrate, and circuit interconnections on the circuit elements; and
a second semiconductor structure on the first semiconductor structure,
wherein the second semiconductor structure includes
a plate layer,
gate electrodes stacked on the plate layer and spaced apart from each other in a first direction perpendicular to an upper surface of the plate layer, the gate electrodes including a lower gate electrode, memory gate electrodes, and an upper gate electrode sequentially stacked on the plate layer,
interlayer insulating layers alternately stacked with the gate electrodes, channel structures in channel holes penetrating through a stack structure of the gate electrodes and the interlayer insulating layers,
a cell region insulating layer on the channel structures,
studs penetrating through the cell region insulating layer and connected to the channel structures, respectively, the studs being in rows in a second direction perpendicular to the first direction,
first separation regions penetrating through the stack structure and extending in the second direction, and
a second separation region penetrating through the cell region insulating layer and the upper gate electrode, the second separation region extending in the second direction and being between two adjacent rows of the studs,
wherein the second separation region overlaps the two adjacent rows of the studs in the second direction, and
wherein an upper surface of the second separation region is coplanar with upper surfaces of the studs.

2. The semiconductor device of claim 1, wherein side surfaces of the second separation region have round portions corresponding to the studs.

3. The semiconductor device of claim 1 or claim 2, wherein the second separation region is in contact with at least one of the studs of the two adjacent rows.

4. The semiconductor device of claim 3, wherein the at least one of the studs of the two adjacent rows has a recessed region from an upper end thereof at a region in contact with the second separation region.

5. The semiconductor device of any preceding claim, wherein the two adjacent rows of the studs are arranged so that central axes of the studs are shifted toward the second separation region from central axes of the channel structures, respectively.

6. The semiconductor device of any preceding claim, wherein diameters of the studs are equal to or larger than a diameter of the channel structures.

7. The semiconductor device of any preceding claim, wherein the second separation region is spaced apart from the channel structures in a horizontal direction.

8. The semiconductor device of claim 7, wherein a portion of the upper gate electrode is between the second separation region and the channel structures.

9. The semiconductor device of any preceding claim, wherein the upper gate electrode includes a first conductive layer and a second conductive layer covering an upper surface and a lower surface of the first conductive layer, and
wherein the second separation region is in contact with both the first conductive layer and the second conductive layer.

10. The semiconductor device of claim 9, wherein
the second conductive layer covers side surfaces of the first conductive layer in regions in which the second conductive layer is in contact with the channel structures, and
the second conductive layer exposes the first conductive layer in a region in which the second conductive layer is in contact with the second separation region.

11. The semiconductor device of any preceding claim, wherein the studs include a different material from the gate electrodes.

12. The semiconductor device of any preceding claim, wherein the second separation region includes an air-gap therein.

13. The semiconductor device of any preceding claim, wherein each of the studs has an inclined side surface to narrow a width thereof toward the channel structures.

14. The semiconductor device of any preceding claim, wherein
each of the channel structures includes a channel layer extending in the first direction and a channel pad filling an interior of the channel layer at an upper end of each of the channel structure,
a lower surface of the channel pad is on a higher level than an uppermost surface of the gate electrodes, and
each of the studs is connected to the channel pad of a corresponding one of the channel structures.

15. A data storage system, comprising:
the semiconductor device of any one of the preceding claims, the semiconductor device further including an input/output pad electrically connected to the circuit elements; and
a controller electrically connected to the semiconductor device through the input/output pad and configured to control the semiconductor device.
